# EUROPÄISCHE PATENTSCHRIFT

(11) **EP 0 931 851 B1**
(45) Veröffentlichungstag und Bekanntmachung des Hinweises auf die Patenterteilung: **11.07.2001**
(21) Anmeldenummer: 99100868.1
(22) Anmeldetag: 19.01.1999
(51) Int. Cl.: C23C 14/04, C23C 14/28, H01J 37/32

(54) **Verfahren zur Erzielung funktioneller Metall-, Keramik- oder Keramik/Metall-Schichten auf der Innenwand von Hohlkörpern**
Method for obtaining functional metallic, ceramic or ceramic/metallic layers on the internal wall of hollow bodies
Procédé permettant l'obtention de couches fonctionnelles métalliques, céramiques ou céramiques/métalliques sur la face interne de corps creux

(30) Priorität: 22.01.1998 DE 19802298
(43) Veröffentlichungstag der Anmeldung: 28.07.1999
(73) Patentinhaber: Astrium GmbH, 81663 München (DE)
(72) Erfinder: Beyer, Steffen, 81667 München (DE); Dietsch, Reiner, 01217 Dresden (DE); Mai, Hermann, 01067 Dresden (DE); Pompe, Wolfgang, 01737 Kurort Hartha (DE)
(74) Vertreter: Baum, Wolfgang, Dipl.-Ing.

(56) Entgegenhaltungen:
- DE-C- 4 339 490
- FR-A- 2 607 830
- PATENT ABSTRACTS OF JAPAN vol. 012, no. 047 (C-475), 12. Februar 1988 & JP 62 192579 A (MITSUBISHI ELECTRIC CORP), 24. August 1987

## Beschreibung

Die Erfindung bezieht sich auf ein Verfahren zur Erzielung funktioneller Metall-, Keramik- oder Keramik/Metall-Schichten auf der Innenwand von Hohlkörpern gemäß dem Oberbegriff des Anspruchs 1.

Solche Verfahren zur Innenwandbeschichtung von Hohlkörpern, insbesondere von kleinen Abmessungen und dünnen Schichten, mittels Laserimpuls-Abscheidung (PLD)sind an sich bekannt. So offenbart die DE 43 39 490 C1 ein Verfahren und eine Vorrichtung zur Innenwand-beschichtung von Hohlkörpern kleiner Abmessungen (< 10 mm), wobei diese Beschichtung mittels PLD erfolgt und gleichmäßige Schichten mit definiert einstellbaren Dicken über die gesamte zu beschichtende Fläche abgeschieden werden können.

Aus der DE 44 17 114 A1 ist ein Verfahren und eine Vorrichtung zur teilchenselektiven Abscheidung dünner Schichten mittels Laserimpuls-Abscheidung (PLD) bekannt, womit die Anzahl an Tröpfchen und Targetteilchen in dünnen Schichten um eine Größenordnung verringerbar sind. Dies wird verfahrensmäßig dadurch erreicht, daß ein Laserimpuls auf der Targetoberfläche ein Laserplasma erzeugt, das in den über der Substratoberfläche liegenden Halbraum gerichtet ist und ein Prozeßgas eingegeben wird, welches in diesem Halbraum ein hochfrequentes elektrisches Feld aufbaut.

Die Beschichtung von Hohlkörper-Innenwänden mit gut haftenden, chemisch und physikalisch homogenen, funktionellen Schichten ist bisher nur für Spezialfälle einigermaßen zufriedenstellend gelöst worden. Insbesondere ergeben sich noch erhebliche Probleme für die Beschichtung von Hohlkörpern mit geringen Innendurchmessern, sowie die Abscheidung von Verbund- und Wechselschichten auf solchen Substraten aus Glas- und Keramikmaterialien und die Synthese von Keramik- und Metall/Keramik-Schichten mit definiertem Gefüge bei vorgegebener Struktur auf Innenwänden beliebiger Materialien.

Der vorliegenden Erfindung liegt die Aufgabe zugrunde, ein Verfahren der eingangs genannten Art aufzuzeigen, mit dem eine direkte homogene Innenbeschichtung von Hohlkörpern, komplexen Geometrien und eine Lokalbeschichtung kleinster Bereiche gewährleistet ist, die höchste Anforderungen bezüglich Oberflächengüte, Reproduzierbarkeit, Haftfestigkeit und extremen thermischen und chemischen Belastungen erfüllt.

Diese Aufgabe wird durch die im Anspruch 1 angegebenen Maßnahmen gelöst. In den Unteransprüchen sind Weiterbildungen und Ausgestaltungen angegeben und in der nachfolgenden Beschreibung sind Ausführungsbeispiele erläutert. Die Figuren der Zeichnung ergänzen diese Erläuterungen. Es zeigen:
- Fig. 1: ein Schemabild des Verfahrens zur Erzielung funktioneller Keramik- oder Metall-Schichten auf der Innenwand von Hohlkörpern mittels PLD
- Fig. 2: ein Schemabild eines Ausführungsbeispiels zur Innenbeschichtung von Raketenbrennkammern mit thermisch und chemisch isolierenden Schichten mittels PLD

Gemäß dem allgemeinen Erfindungsgedanken wird die Anwendung des PLDVerfahrens (Pulsed Laser Deposition) in Kombination mit einer Laser-Dünnschicht-Behandlung zur Innenbeschichtung von Hohlkörpern mit Keramik-, Metall- und Metall/Keramik-Schichten mit definierten funktionellen und Struktur/Gefüge-Eigenschaften vorgeschlagen. Hieraus ergeben sich eine ganze Anzahl wesentlicher Vorteile des PLD-Verfahrens, wobei besonders die Realisierung präzise steuerbarer thermodynamischer Prozeßbedingungen auch im Mikroreaktionsvolumen hervorzuheben ist. Durch vorgegebene Energie- und Materiestromdichten als Funktion des Abstandes des Kondensationsbereiches von der Substratoberfläche wird dies ermöglicht. Da hierbei ein Kurzzeitimpulsregime zur Verwendung kommt, werden höchstmögliche Teilchen- und Energiedichten im Kondensations-bereich von der Substratoberfläche realisiert.

Unter Anwendung der PLD ist es möglich, effektive Beschichtungen der Innenwände von Hohlkörpern mit kleinen Innenabmessungen und/oder komplizierter Geometrie durchzuführen, wobei die Beschichtungsprodukte eine hohe chemische und physikalische Reinheit aufweisen. Mit dem hier vorgeschlagenen Verfahren ist es möglich, die Innenwände von Hohlkörpern beispielsweise mit einer Länge von bis zu 650 mm bei einem Innendurchmesser von minimal 7 mm zu beschichten. Das Schicht- oder Targetmaterial kann dabei aus leitenden oder aus isolierenden Substanzen bestehen. Die Plasmastrom-Erzeugung ist von beliebigen, im Vakuum bearbeitbaren Schichtwerkstoffen gegeben. Einschränkungen bezüglich der Targetmaterialien ergeben sich lediglich aus ihrer Vakuumtauglichkeit. Mit Hilfe einer speziellen Vorrichtung gestattet das vorgeschlagene Verfahren auch die Innenbeschichtung von einseitig verschlossenen Hohlkörpern.

Zum besseren Verständnis wird nachfolgend ein konkretes Ausführungsbeispiel beschrieben:

Ein Target 10 aus ZrO₂ (Keramik) wird mit Festkörper-, CO₂-TEA oder Eximer-Laser 11 beschossen. Es werden Laserimpulse 11a mit Energien von 1 - 2 Joule bei Wiederholungspulsraten von 10 bis 50 Hz verwendet. Für unterschiedliche Impulslängen der Größenordnungen Nanosekunden (ns) bzw. Mikrosekunden (µs) erfolgt ein Materialabtrag in 13Dampf- bzw. Plasmaform, bei dessen Kondensation auf der Hohlkörperinnenwand 14 das Wachstum einer dünnen ZrO₂-Schicht 15 erfolgt. Je nach gewählter Impulslänge und Restgasatmosphäre in der Abscheidekammer 16 kann ein typisches Schichtgefüge - glasartig-amorph, kolumnar oder polykristallin - erzeugt werden. Der Aufbau gradierter Schichtsysteme (kontinuierliche Eigenschaftsänderung) erfolgt dann durch eine diskrete oder kontinuierliche Änderung der Prozeßparameter, insbesondere der Laserenergiedichte, der Impulslänge und der Restgasatmosphäre.

Der Zusatzlaser 17 oder auch die Beschichtungslaser 11 werden zur direkten Bestrahlung der gewachsenen Schicht 15 eingesetzt. Dabei bewirkt die eingetragene Laserstrahlenergie eine entsprechend rasche Aufheizung der Schichtoberfläche und die nachfolgende Schnellabkühlung ein "Einfrieren" des überhitzten Schichtzustandes und damit eine Konservierung des temporären Schmelzzustandes. Die gleichmäßige Verteilung der eingefrorenen Schmelze über die Oberfläche erzeugt so eine Versiegelung der ursprünglich porösen Schicht-Oberfläche. Dabei wird die Laserbehandlungszone in ihrer Ausdehnung durch die Absorptionstiefe der jeweiligen Wellenlänge des Laserlichts in der Schichtoberfläche und den Strahlquerschnitt auf der Schicht definiert.

Heterogene Verbundwerkstoffe, in denen sich mechanische, physikalische und chemische Werkstoffeigenschaften kontinuierlich ändern und bei denen keine Diskontinuitäten im Material existieren, werden als Gradienten-Werkstoff bezeichnet. Wird hier der Gefügegradient zum Erzielen von Eigenschaftskombinationen eingestellt, beispielsweise bei einer Schicht mit hoher Wärmedämmung bei gleichzeitig guter Bindung an einen metallischen Grundkörper, so spricht man von funktionalen Gradienten-Werkstoffen.

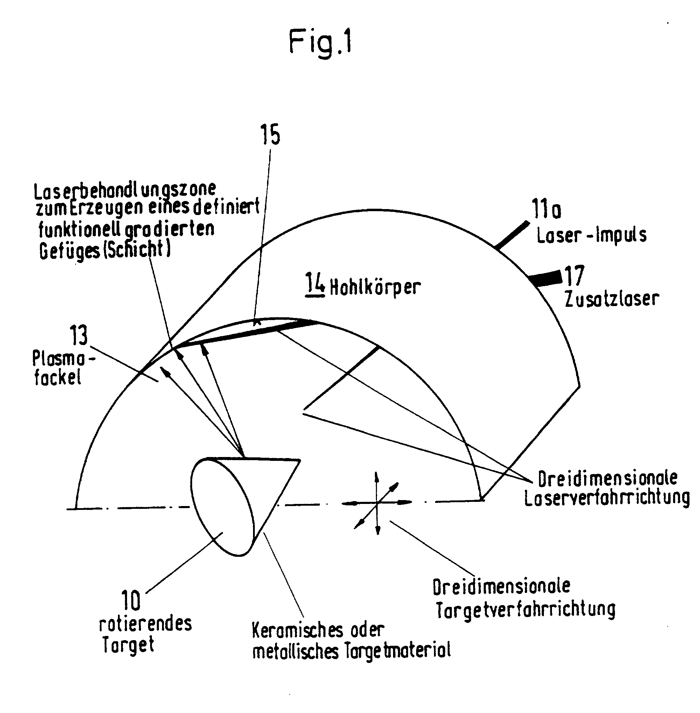

Wie in Fig. 1 skizziert, geschieht die Target- und Substratbewegung durch Schrittmotoren, die mittels Rechnersteuerung eine Bewegung in den drei Koordinatenachsen bewirken

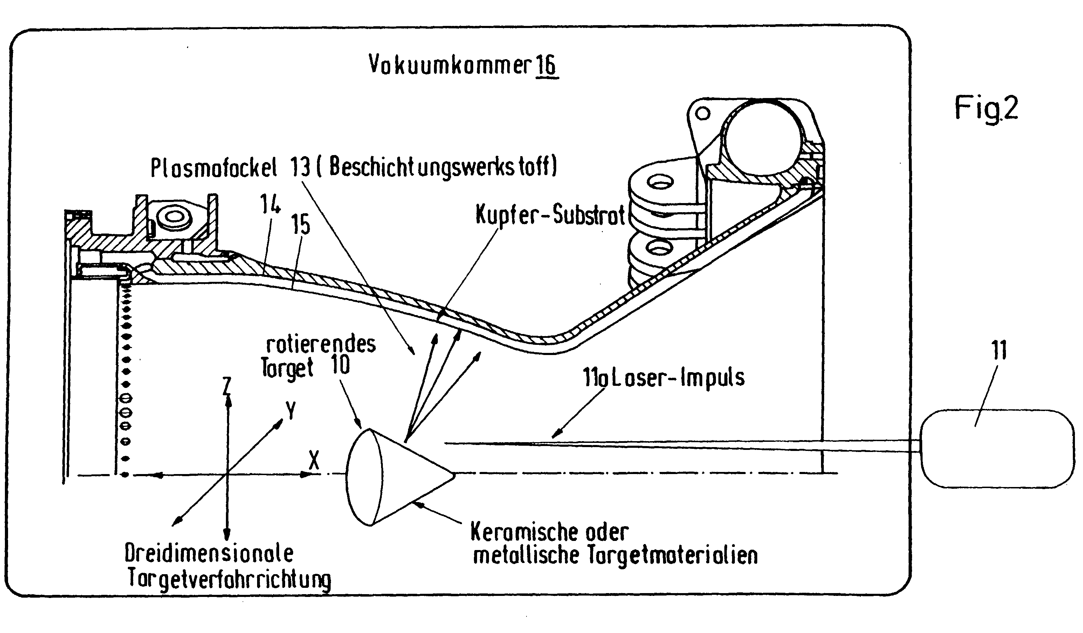

Ein weiteres Ausführungsbeispiel des erfindungsgemäßen Verfahrens bezieht sich auf die Innenbeschichtung von Brennkammern, besonders von Raketenbrennkammern, und ist in der Fig.2 schematisch dargestellt: Die Brennkammern von Hochleistungstriebwerken sind extremen thermischen und chemischen Belastungen ausgesetzt. Als Folge dessen ist die Lebensdauer stark limitiert. Mit dem vorgeschlagenen Verfahren wird eine Innenbeschichtung der hochwärmeleitenden Brennkammerwände mit thermisch isolierenden und chemisch beständigen Werkstoffen ermöglicht und damit die Lebensdauer wesentlich erhöht. Auch hier kommt das PLD-Verfahren zum Tragen, das nachfolgend die zentralen Anforderungen an Beschichtungen erfüllt.
a) Bisher war die Schichtdicke d aufgrund der hohen Wärmestromdichten auf dₘₐₓ ca. 20 µm begrenzt. Das erfindungsgemäße Verfahren gewährleistet eine präzise Präparation auch dünner, homogener Schichten - beispielsweise d = atomare Monolagen bis ca. 100 µm - und schafft die Möglichkeit der Synthese funktionell "gradierter Schichten" mit Gesamtdicken im Bereich von d = 1 bis 100 µm zur Begrenzung von Spannungsspitzen an den Interfacen - beispielsweise zwischen Substrat und erster Schicht.
b) Ohne Nacharbeit wird eine im Nanometerbereich liegende beste Oberflächengüte erreicht, wobei sich die Substratoberfläche abbildet.
c) Ein höchstes Maß an Homogenität und Reproduzierbarkeit der Schichten, ihrer Eigenschaften und ihrer Zusammensetzung wird erreicht und durch die hohen spezifischen Energiedichten der Schichtwerkstoffe in der Gasphase ist eine höchstmögliche Haftfestigkeit gewährleistet.
d) Ferner ist eine hohe Verfahrensflexibilität bei extremen Abscheidegeometrien - beispielsweise die Brennkammerkontur - gegeben durch die räumliche Trennung von der Beschichtungszone und extern positionierbarer Energiequellen.
e) Nicht zu unterschätzen ist die Möglichkeit der präzisen Lokalbeschichtung kleinster Bereiche als Regenerierungs- bzw. Reparaturmöglichkeit für Raketenbrennkammern und damit verbunden eine erhebliche Kosteneinsparung im Gegensatz zu einer kompletten Neubeschichtung.

## Patentansprüche

1. Verfahren zur Erzielung von Metall-, Keramik- oder Keramik/Metall-Schichten auf der Innenwand von Hohlkörpern, umfassend die folgenden Schritte:
a) bewegliche Anordnung eines Targetmaterials (10), welches aus einer Keramik und/oder aus einem Metall besteht innerhalb eines Hohlkörpers in einer Vakuum-Abscheidungskammer (16),
b) Erzeugung eines Vakuums mit einer definierten Restgasatmosphäre in der Vakuum-Abscheidungskammer (16),
c) Bestrahlung des Targetmaterials (10) mit einem ersten gepulsten Laserstrahl (11a) zur Verdampfung eines Teils des Targetmaterials (10) und zur Kondensation des verdampften Targetmaterials (10) auf der Innenwand (14) des Hohlkörpers zur Bildung einer Schicht (15),
d) Bestrahlung der Schicht (15) zur Aufheizung der Oberfläche der Schicht (15) durch einen zweiten Laserstrahl und
e) Schnellabkühlung der Schicht (15) zur Bildung einer eingefrorenen Schmelze.

2. Verfahren nach Anspruch 1, dadurch gekennzeichnet, dass der erste Laserstrahl (11a) und der zweite Laserstrahl durch separate Laserquellen (11, 17) erzeugt werden.

3. Verfahren nach Anspruch 1, **dadurch gekennzeichnet,** dass der erste Laserstrahl (11a) und der zweite Laserstrahl durch eine gemeinsame Laserquelle (11) erzeugt werden.

4. Verfahren nach einem der Ansprüche 1 bis 3, **dadurch gekennzeichnet,** dass durch eine diskrete oder kontinuierliche Änderung der Prozessparameter Laserenergiedichte, Impulslänge und Restgasatmosphäre gradierte Schichtsysteme (15) erzeugt werden.

5. Verfahren nach Anspruch 4, **dadurch gekennzeichnet,** dass die Energiedichte der Laserimpulse (11a) zwischen 1 und 2 Joule und die Wiederholfrequenz der Laserimpulse zwischen 10 und 50 Hz gewählt wird.

6. Verfahren nach einem der Ansprüche 1 bis 5, **dadurch gekennzeichnet,** dass die Laserquellen (11) und das Targetmaterial (10) dreidimensional verfahrbar angeordnet werden.

7. Verfahren nach Anspruch 6, **dadurch gekennzeichnet,** dass zur dreidimensionalen Verfahrbarkeit rechnergesteuerte Schrittmotoren verwendet werden.

## Claims

1. A method of obtaining metallic, ceramic or metallic/ceramic layers on the internal walls of hollow bodies, comprising the following steps:
a) Movably arranging a target material (10), consisting of a ceramic and/or of a metal within a hollow body in a vacuum-precipitation chamber (16),
b) Generating a vacuum with a defined residual-gas atmosphere in the vacuum-precipitation chamber (16),
c) Irradiating the target material (10) with a first pulsed laser beam (11a) to evaporate part of the target material (10) and to condense the evaporated target material (10) on the internal wall (14) of the hollow body to form a layer (15),
d) Irradiating the layer (15) to heat the surface of the layer (15) by a second laser beam, and
e) Rapidly cooling the layer (15) to form a deep-frozen melt.

2. A method according to Claim 1, characterised in that the first laser beam (11a) and the second laser beam are generated by separate laser sources (11, 17).

3. A method according to Claim 1, **characterised in that** the first laser beam (11a) and the second laser beam are generated by a common laser source (11).

4. A method according to one of Claims 1 to 3, **characterised in that** graduated layer systems (15) are generated by discrete or continuous alteration of the process parameters laser-energy intensity, impulse length and residual-gas atmosphere.

5. A method according to Claim 4. **characterised in that** the selected energy intensity of the laser impulses (11a) is between I and 2 joules and the selected repeat frequency of the laser impulses is between 10 and 50 Hz.

6. A method according to one of Claims 1 to 5. **characterised in that** the laser sources (11) and the target material (10) are arranged so as to be movable in three dimensions.

7. A method according to Claim 6, **characterised in that** computer-driven stepping motors are used to achieve three-dimensional movability.

## Revendications

1. Procédé de production de couches de métal, de céramique ou de céramique/métal sur la paroi interne de corps creux, comprenant les étapes suivantes :
a) disposition mobile d'un matériau cible (10), qui est constitué d'une céramique et/ou d'un métal à l'intérieur d'un corps creux dans une chambre de revêtement sous vide (16),
b) production d'un vide avec une atmosphère de gaz résiduel défini dans la chambre de dépôt sous vide (16),
c) irradiation du matériau cible (10) avec un premier rayon laser à impulsions (11a) pour la vaporisation d'une partie du matériau cible (10) et pour la condensation du matériau cible vaporisé (10) sur la paroi interne (14) du corps creux en vue de la formation d'une couche (15),
d) irradiation de la couche (15) pour le chauffage de la surface de la couche (15) par un second rayon laser et
e) refroidissement rapide de la couche (15) pour la formation d'une masse fondue figée.

2. Procédé selon la revendication 1,
caractérisé en ce que
le premier rayon laser (11a) et le second rayon laser sont produits par des sources laser séparées(11,17).

3. Procédé selon la revendication 1,
caractérisé en ce que
le premier rayon laser (11a) et le second rayon laser sont produits par une source laser commune (11).

4. Procédé selon l'une quelconque des revendications 1 à 3,
caractérisé en ce que
par une modification discrète ou continue des paramètres du procédé, l'énergie laser, la longueur d'impulsion et l'atmosphère en gaz résiduel, on produit des systèmes de couches (15) gradués.

5. Procédé selon la revendication 4,
caractérisé en ce que
la densité d'énergie des impulsions laser (11a) est choisie entre 1 et 2 joules, et la fréquence des impulsions laser est choisie entre 10 et 50 Herz.

6. Procédé selon l'une quelconque des revendications 1 à 5,
caractérisé en ce que
les sources laser (11) et le matériau cible (10) sont disposés de manière tridimensionnellement déplaçable.

7. Procédé selon la revendication 6,
caractérisé en ce qu'
on utilise pour la possibilité de déplacement tridimensionnel des moteurs pas à pas commandés par ordinateur.
